# EUROPÄISCHE PATENTANMELDUNG

(11) **EP 2 184 962 A2**
(43) Veröffentlichungstag der Anmeldung: **12.05.2010**
(21) Anmeldenummer: 09450213.5
(22) Anmeldetag: 06.11.2009
(51) Int. Cl.: H05K 5/06

(54) **Elektrische Vorrichtung mit einer elektrischen Bauteileanordnung und mit einem Gehäuse**

(30) Priorität: 07.11.2008 AT 17292008
(71) Anmelder: Egston System Electronics Eggenburg Gmbh, 3730 Eggenburg (AT)
(72) Erfinder: Prand-Stritzko, Ernst, 2091 Langau (AT)
(74) Vertreter: Gibler & Poth Patentanwälte OEG

(57) **Zusammenfassung**

Bei einer elektrischen Vorrichtung (10) mit einem Gehäuse (20), insbesondere einem staubund/oder wasserdichten Gehäuse (20), wobei das Gehäuse (20) eine erste Gehäuseschale (1) und eine zweite Gehäuseschale (2) umfasst, wobei die erste Gehäuseschale (1) eine Grundfläche (11) und eine geschlossene erste Mantelfläche (12) und die zweite Gehäuseschale (2) eine Deckfläche (21) und eine geschlossene zweite Mantelfläche (22) umfasst, wobei unter Ausbildung eines Gehäusehohlraums (30) die zweite Gehäuseschale (2) wenigstens bereichsweise innerhalb der ersten Gehäuseschale (1) angeordnet ist, wobei die zweite Mantelfläche (22) wenigstens bereichsweise von der ersten Mantelfläche (12) umschlossen ist, wobei zwischen der ersten Mantelfläche (12) und der zweiten Mantelfläche (22) ein Mantelspalt (4) ausgebildet ist, wird zur zuverlässigen Abdichtung des Gehäusehohlraums (30) vorgeschlagen, dass der Mantelspalt (4) mit einer Vergussmasse (5) verschlossen ist.

## Beschreibung

Die Erfindung betrifft eine elektrische Vorrichtung gemäß dem Oberbegriff des Patentanspruches 1.

Elektrische Vorrichtungen sind bekannt. Diese werden in Haushaltsgeräten, in Industrieanlagen sowie in Verkehrsmitteln, insbesondere im Automobilbau und/oder in der Luftfahrtindustrie, in unterschiedlichsten Ausführungen eingesetzt. Derartige elektrische Vorrichtungen können Spannungswandler, Signalverarbeitungseinrichtungen, Computereinheiten, Sensoren und dergleichen ausbilden.

Nachteilig bei herkömmlichen elektrischen Vorrichtungen ist die oftmals schlechte Dichtheit, womit Staub und/oder Wasser in die elektrische Vorrichtung eindringen kann. Dabei können bereits kleine Mengen von Staub und/oder Wasser ausreichen, um in der elektrische Vorrichtung Kurzschlüsse zu bewirken und/oder von der elektrischen Vorrichtung umfasste Bauteile, insbesondere elektrische Bauteile, vorzeitig zu altern beziehungsweise vorzeitig zu korrodieren.

Um das Eindringen von Staub und/oder Wasser in die elektrische Vorrichtung zu verhindern, kann das Gehäuse einer elektrischen Vorrichtung mit einer Vergussmasse ausgefüllt sein. Nachteilig ist dabei insbesondere, dass die elektrische Vorrichtung dadurch schwer wird.

Ebenso kann zur Verhinderung des Eindringens von Staub und/oder Wasser in die elektrische Vorrichtung vorgesehen sein, dass das Gehäuse oberflächig versiegelt ist. Dazu kann das Gehäuse verschweißt sein oder Dichtungen können zwischen Gehäuseteilen angeordnet werden. Nachteilig dabei ist, dass die Versiegelung aufwendig und teuer ist. Nachteilig dabei ist weiters, dass das Gehäuse - zum Ausgleich zwischen einem Gehäuseinnendruck und einem Umgebungsdruck - hiebei im allgemeinen Mittel zum Druckausgleich aufweisen muss, da bei einem zu hohen Druckunterschied zwischen dem Gehäuseinnendruck und dem Umgebungsdruck die Versiegelung beschädigt werden würde.

Aufgabe der Erfindung ist es eine elektrische Vorrichtung mit einem Gehäuse anzugeben, welches Gehäuse staub- und/oder wasserdicht ausgebildet sein kann, wobei die obigen Nachteile vermieden sind und wobei vorgesehen ist, dass die elektrische Vorrichtung, kostengünstig, mit geringem Gewicht und ohne Mittel zum Druckausgleich ausgebildet werden kann.

Erfindungsgemäß wird dies durch die Merkmale des Patentanspruches 1 erreicht.

Vorteilhaft dabei ist, dass die elektrische Vorrichtung lediglich teilweise mit der Vergussmasse ausgefüllt ist, womit Materialkosten und Gewicht eingespart werden können.

Vorteilhaft dabei ist, dass derart die Vergussmasse den Mantelspalt zuverlässig ausfüllt, so dass auf vom Gehäuse umfasste Mittel zum Druckausgleich verzichtet werden kann, womit die Herstellkosten gesenkt werden können. Insbesondere ist dies vorteilhaft, da oftmals die Mittel zum Druckausgleich fehleranfällig sind und die Lebensdauer der elektrischen Vorrichtung beschränken.

Vorteilhaft dabei ist weiters, dass derart gewährleistet werden kann, dass die elektrische Vorrichtung je nach Anforderung und gewähltem Material der Gehäuseschalen kostengünstig und mit geringem Gewicht erfüllen kann.

Besonders bevorzugt kann vorgesehen sein, dass die zweite Mantelfläche eine freie Mantelkante aufweist, dass die freie Mantelkante vollumfänglich geschlossen ist, dass die freie Mantelkante benachbart beabstandet zur Grundfläche angeordnet ist, und dass die freie Mantelkante vollständig innerhalb der Vergussmasse angeordnet ist. Derart kann die Abdichtung des Gehäuses besonders zuverlässig sein und die Vergussmasse kann eine Versteifung des Gehäuses bewirken.

Die Erfindung betrifft auch ein Verfahren zur Herstellung der elektrischen Vorrichtung gemäß dem Oberbegriff des Patentanspruches 12.

Aufgabe des Verfahrens ist es, einfach und kostengünstig eine elektrische Vorrichtung mit einem Gehäuse herzustellen, wobei das Gehäuse staub- und/oder wasserdicht ausgebildet werden kann, und wobei mit der elektrischen Vorrichtung die eingangs genannten Nachteile vermieden werden können.

Erfindungsgemäß wird dies mit den Merkmalen des Patentanspruches 12 erreicht.

Vorteilhaft bei dem Verfahren ist, dass es einfach, schnell und kostengünstig durchgeführt werden kann. Vorteilhaft dabei ist weiters, dass das Verfahren sowohl mit hohem manuellen Arbeitsanteil als auch gut automatisierbar durchgeführt werden kann, womit sowohl Kleinserien als auch Großserien kostengünstig und ressourcenschonend herstellbar sind.

Die Unteransprüche, welche ebenso wie die Patentansprüche 1 und 12 gleichzeitig einen Teil der Beschreibung bilden, betreffen weitere vorteilhafte Ausgestaltungen der Erfindung.

Die Erfindung wird unter Bezugnahme auf die beigeschlossenen Zeichnungen, in welchen lediglich bevorzugte Ausführungsformen beispielhaft dargestellt sind, näher beschrieben. Dabei zeigt:
Fig. 1 schematisch eine Explosionsdarstellung der elektrischen Vorrichtung einer besonders bevorzugten ersten Ausführungsform in Schrägansicht;
Fig. 2 schematisch eine Explosionsdarstellung der elektrischen Vorrichtung einer besonders bevorzugten zweiten Ausführungsform in Schrägansicht;
Fig. 3 einen ersten Schnitt durch die elektrische Vorrichtung gemäß Fig. 1 in schematischer Darstellung in Blickrichtung parallel zur Frontsicht auf die elektrische Vorrichtung;
Fig. 4 einen zweiten Schnitt durch die elektrische Vorrichtung gemäß Fig. 1 in schematischer Darstellung in Blickrichtung parallel zur Seitenansicht auf die elektrische Vorrichtung;
Fig. 5 einen ersten Schnitt durch die elektrische Vorrichtung gemäß Fig. 2 in schematischer Darstellung in Blickrichtung parallel zur Frontsicht auf die elektrische Vorrichtung;
Fig. 6 einen zweiten Schnitt durch die elektrische Vorrichtung gemäß Fig. 2 in schematischer Darstellung in Blickrichtung parallel zur Seitenansicht auf die elektrische Vorrichtung;
Fig. 7 in geschnittener schematischer Darstellung im Detail eine erste Ausbildung von Positioniermitteln bzw. Befestigungsmitteln der elektrischen Vorrichtung;
Fig. 8 in geschnittener schematischer Darstellung im Detail eine zweite Ausbildung von Positioniermitteln bzw. Befestigungsmitteln der elektrischen Vorrichtung;
Fig. 9 schematisch geschnitten eine vorteilhafte dritte Ausführungsform der elektrischen Vorrichtung; und
Fig. 10 schematisch geschnitten eine vorteilhafte vierte Ausführungsform der elektrischen Vorrichtung.

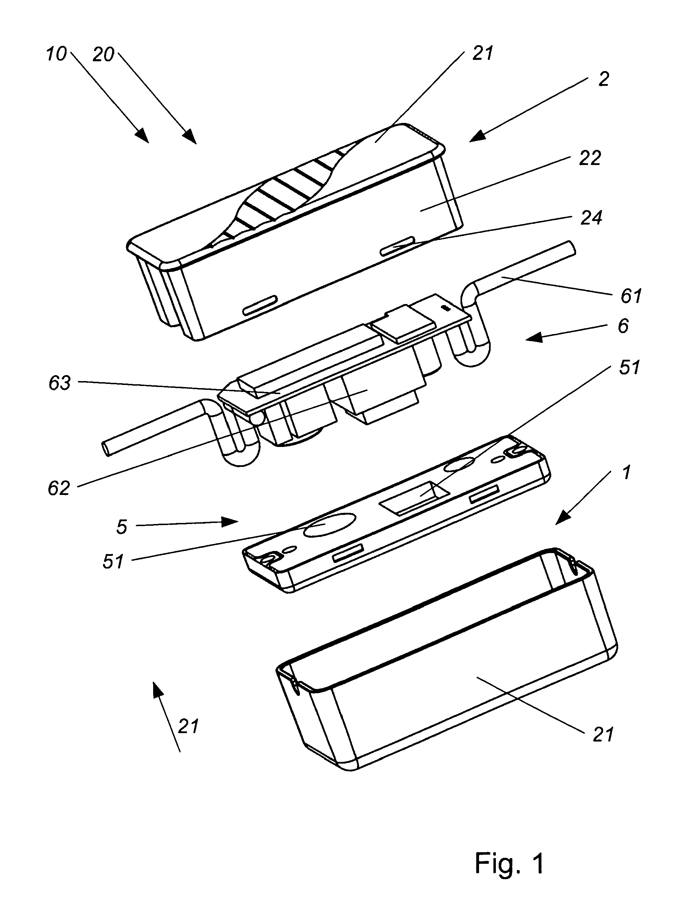

Die Fig. 1 bis 10 zeigen zumindest Teile einer elektrische Vorrichtung 10 mit einem Gehäuse 20, insbesondere einem staub- und/oder wasserdichten Gehäuse 20, wobei das Gehäuse 20 eine erste Gehäuseschale 1 und eine zweite Gehäuseschale 2 umfasst, wobei die erste Gehäuseschale 1 eine Grundfläche 11 und eine geschlossene erste Mantelfläche 12 und die zweite Gehäuseschale 2 eine Deckfläche 21 und eine geschlossene zweite Mantelfläche 22 umfasst. Unter Ausbildung eines Gehäusehohlraums 30 ist dabei die zweite Gehäuseschale 2 wenigstens bereichsweise innerhalb der ersten Gehäuseschale 1 angeordnet, wobei die zweite Mantelfläche 22 wenigstens bereichsweise von der ersten Mantelfläche 12 umschlossen ist, und wobei zwischen der ersten Mantelfläche 12 und der zweiten Mantelfläche 22 ein Mantelspalt 4 ausgebildet ist. Zur zuverlässigen Abdichtung des Gehäusehohlraums 30 wird hiebei vorgeschlagen, dass der Mantelspalt 4 mit einer Vergussmasse 5 verschlossen ist, insbesondere vollständig verschlossen ist. Dabei ist der Mantelspalt 4 von der ersten Mantelfläche 12 vollumfänglich umschlossen. Der Mantelspalt 4 ist jener Spalt, welcher zwischen der ersten Mantelfläche 12 und der zweiten Mantelfläche 22 des zumindest im Wesentlichen geschlossenen Gehäuses 20 ausgebildet ist.

Vorteilhaft dabei ist, dass die Vergussmasse 5 die beiden Gehäuseschalen 1, 2 mit besonderer Zuverlässigkeit versiegelt und dabei Kräfte übertragen werden können. Vorteilhaft dabei ist insbesondere, dass innerhalb des Gehäuses 20 ein Gehäusehohlraum 30 ausgebildet ist, welcher insbesondere luftdicht ausgebildet sein kann, wobei kein luftähnliches Gas aus dem Gehäusehohlraum 30 nach außen dringen kann und kein luftähnliches Gas in den Gehäusehohlraum 30 eindringen kann.

Vorteilhafterweise kann die elektrische Vorrichtung 10 dabei mit besonders geringem Gewicht ausgebildet sein. Aufgrund steigender Energie und Treibstofflcosten ist das geringe Gewicht der elektrischen Vorrichtung 10 insbesondere in der Automobil- und Flugzeugindustrie von besonderer Bedeutung.

In vorteilhafter Weise hat sich dabei gezeigt, dass derart das Gehäuse 20 zuverlässig abgedichtet werden kann. Insbesondere kann das Gehäuse auch bei Druckunterscheiden zwischen einem Gehäuseinnendruck und einem Umgebungsdruck von bis zu zwei Atmosphären, also von bis zu 20 kPa, luftdicht ausgebildet sein. Insbesondere kann dabei auf am Gehäuse 20 ausgebildete Mittel zum Druckausgleich zwischen dem Gehäuseinnendruck und dem Umgebungsdruck verzichtet werden, womit die Herstellkosten gesenkt werden können und womit die Zuverlässigkeit und die Dauerhaftigkeit der Staubdichtheit und/oder Wasserdichtheit besonders hoch sein kann.

Vorteilhaft ist weiters, dass bei luftdichter Ausbildung des Gehäuses dieses üblicherweise auch staubdicht und wasserdicht ausgebildet ist. Derart können beispielsweise sämtliche IP-Schutzklassen gemäß DIN 40050, insbesondere also die IP-Schutzklassen IP66, IP66k, IP67, IP68 und IP69k, einfach, kostengünstig und mit geringem Gewicht der elektrischen Vorrichtung 10 erfüllt werden.

Insbesondere kann das Gehäuse derart zweiteilig ausgebildet sein, wobei die erste Gehäuseschale 1 als erstes Gehäuseteil und die zweite Gehäuseschale 2 als zweites Gehäuseteil bezeichnet werden kann.

Die Ausführungsformen, insbesondere die vorteilhaften und die besonders bevorzugten Ausführungsformen, der elektrischen Vorrichtung 10 können insbesondere in einem Verfahren zur Herstellung der elektrischen Vorrichtung 10 mit dem Gehäuse 20, insbesondere dem staub- und/oder wasserdichten Gehäuse 20, hergestellt werden, welches zumindest die folgenden Schritte umfasst:
- dass in einem Schalenanordnungsschritt, also einem Schritt zur Anordnung der zweiten Gehäuseschale 2 relativ zur ersten Gehäuseschale 1, die zweite Mantelfläche 22 der zweiten Gehäuseschale 2 derart bereichsweise in die erste Mantelfläche 12 der ersten Gehäuseschale 1 geführt, insbesondere geschoben, wird, dass die zweite Mantelfläche 22 zumindest bereichsweise von der ersten Mantelfläche 12 umschlossen wird, und dass zwischen der ersten Mantelfläche 12 und der zweiten Mantelfläche 22 ein Mantelspalt 4 ausgebildet wird, und
- dass in einem Vergussbefüllschritt, also einem Schritt zur Befüllungs der ersten Gehäuseschale 1 mit der Vergussmasse 5, die erste Gehäuseschale 1 bis zu einer vorbestimmbaren Vergussfüllhöhe 92 mit der Vergussmasse 5 befüllt wird.

Da dabei die erste Gehäuseschale 1 bereichsweise mit Vergussmasse 5 befüllt wird, kann diese - zumindest bereichsweise - wannenförmig ausgebildet sein und als Gehäusewanne bezeichnet werden.

In diesem Zusammenhang kann vorgesehen sein, dass - in zeitlicher Abfolge - der Schalenanordnungsschritt vor dem Vergussbefüllschritt durchgeführt wird. Dazu kann die vorbestimmbare Menge Vergussmasse 5 in den Mantelspalt 4 eingefüllt werden und durch den Mantelspalt 4 hindurch im Gehäuse 20 verteilt werden.

In anderer Reihenfolge des Verfahrensablaufs kann vorgesehen sein, dass - in zeitlicher Abfolge - der Vergussbefüllschritt vor dem Schalenanordnungsschritt durchgeführt wird. Dazu kann die vorbestimmbare Menge Vergussmasse 5 in die, dazu in einer Montagelage angeordnete, erste Gehäuseschale 1 eingefüllt werden und die zweite Gehäuseschale bereichsweise in die Vergussmasse 5 eingeführt, insbesondere eingeschoben, werden. Vorteilhaft dabei ist, dass auf Mantelspalten 4 mit geringer Spaltbreite zuverlässig mit Vergussmasse 5 befüllbar sind.

Vorteilhafterweise kann vorgesehen sein, dass im Vergussbefüllschritt das Gehäuse 20 geschwenkt wird, wodurch die Verteilung der Vergussmasse 5 verbessert werden kann.

Nach dem Schalenanordnungsschritt sowie dem Vergussbefüllschritt kann, insbesondere in einem weiteren Schritt, die Vergussmasse 5 eine vorbestimmbare Zeit aushärten, welches auch bei erhöhter Temperatur, also oberhalb der Raumtemperatur von üblicherweise 23°C, erfolgen kann. Dieser Schritt kann als Aushärteschritt bezeichnet werden.

Die Vergussmasse 5 kann als natürlicher oder künstlicher Klebstoff und/oder als natürliches oder künstliches Kunststoffharz, beispielsweise als Aminoplast, Epoxidharz und/oder als Phenolharz, ausgebildet sein. Insbesondere kann die Vergussmasse 5 im flüssigen Zustand derart ausgebildet sein, dass diese auch in Spalten, insbesondere Mantelspalten 4, mit geringer Breite, beispielsweise unter 0,1mm, eindringen kann. Insbesondere kann die Vergussmasse 5 ebenso derart ausgebildet sein, dass die Vergussmasse 5 innerhalb weniger Minuten bis Stunden erhärtet.

Der Vergussmasse 5 können weitere Stoffe, insbesondere Füllstoffe zugegeben werden. Beispielsweise können zur Erhöhung der Festigkeit der Vergussmasse 5 Fasern, insbesondere Glasfasern oder Kohlenstofffasern, beigemengt werden. Auch kann die Vergussmasse mittels Treibmitteln geschäumt werden.

Zur weiteren Gewichtminimierung können der Vergussmasse 5 Füllstoffe geringer Dichte, beispielsweise Styroporschaumkugeln, beigemengt werden.

Bei weiteren vorteilhaften Ausbildungen der Vergussmasse 5 kann diese mit die thermische Leitfähigkeit verbessernden Stoffen, beispielsweise Graphit, versetzt sein.

Insbesondere kann vorgesehen sein, dass die zweite Mantelfläche 22, im Bereich, in welchem diese beabstandet zur Vergussmasse 5 angeordnet ist, durchbrechungsfrei ausgebildet ist, wie diese bei der ersten, der zweiten, der dritten und der vierten Ausführungsform der elektrischen Vorrichtung 10 vorgesehen ist. Vorteilhaft dabei ist, dass lediglich zumindest der Mantelspalt 4 mittels der Vergussmasse 5 abzudichten ist. Vorteilhaft dabei ist, dass hiebei wenigstens eine Kontaktierungsleitung 61 zur elektrischen Kontaktierung der elektrische Vorrichtung (10), insbesondere mit externen Leitungen und/oder elektrischen Einrichtungen im Mantelspalt 4 und durch den Mantelspalt 4 hindurch verlegt werden kann. Als vorteilhaft hat sich dabei erwiesen, dass die Kontaktierungsleitungen 61 hiebei ebenso bereichsweise vollumfänglich von der Vergussmasse 5 umschlossen sind. Dabei kann die Luftdichtheit des Gehäuses trotz hindurchgeführter Kontaktierungsleitungen 61 weiterhin gewährleistet werden, wobei die Abdichtung der Kontaktierungsleitungen 61 durch die Vergussmasse 5 gewährleistet sein kann. In diesem Zusammenhang kann vorgesehen sein, dass - zur Verbesserung des Anhaftens der Vergussmasse 5 an den Kontaktierungsleitungen 61 - die Kontaktierungsleitungen 61 eine strukturierte Oberfläche aufweisen.

In Fig. 1 ist in schematischer Schrägansicht eine besonders bevorzugte erste Ausführungsform der elektrischen Vorrichtung 10 in einer Explosionsdarstellung dargestellt. Dargestellt sind die erste Gehäuseschale 1, die zweite Gehäuseschale 2, eine elektrische Bauteileanordnung 6 und die - bereits erhärtet dargestellte - Vergussmasse 5 der elektrischen Vorrichtung 10.

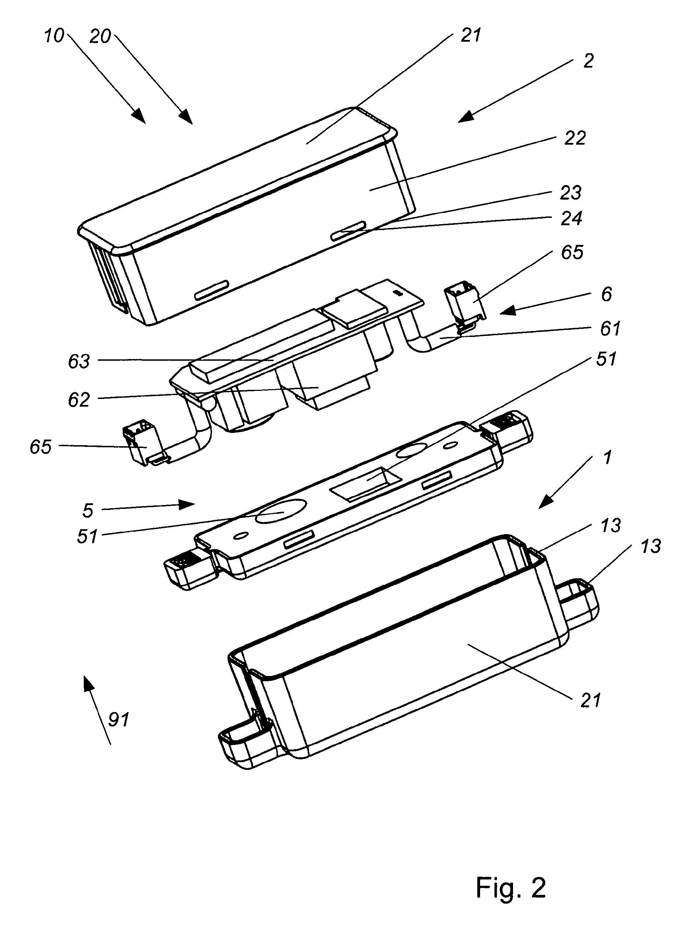

Auch in Fig. 2 ist in schematischer Schrägansicht eine besonders bevorzugte zweite Ausführungsform der elektrischen Vorrichtung 10 in einer Explosionsdarstellung dargestellt.

Die zweite Ausführungsform unterscheidet sich von der ersten Ausführungsform im Wesentlichen in der Ausgestaltung der Kontaktierungsleitungen 61. Die unterschiedliche Ausgestaltung der Kontaktierungsleitungen 61 kann in der zweiten Ausführungsform der elektrischen Vorrichtung 10 eine unterschiedliche Ausgestaltung der beiden Mantelflächen 12, 22 zu jenen Mantelflächen 12, 22 der ersten Ausführungsform der elektrischen Vorrichtung 10 bewirken.

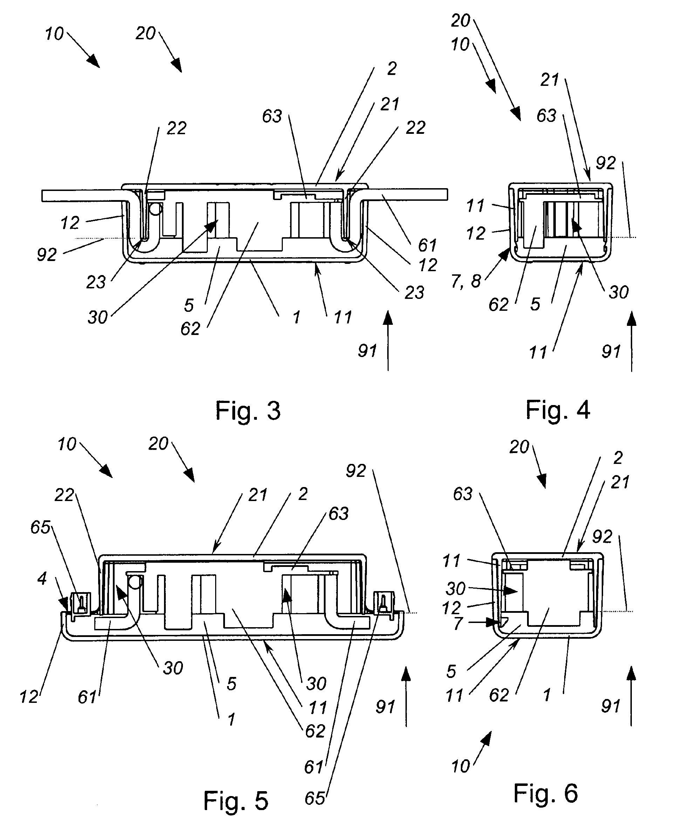

In Fig. 3 und Fig. 4 sind schematisch zwei Querschnitte durch die elektrische Vorrichtung 10 gemäß Fig. 1 dargestellt, wobei Fig. 3 einen Querschnitt parallel zur Fronsicht auf die elektrische Vorrichtung 10 zeigt und Fig. 4 einen Querschnitt parallel zur Seitenansicht auf die elektrische Vorrichtung 10 zeigt.

In Fig. 5 und Fig. 6 sind schematisch zwei Querschnitte durch die elektrische Vorrichtung 10 gemäß Fig. 2 dargestellt, wobei Fig. 5 einen Querschnitt parallel zur Fronsicht auf die elektrische Vorrichtung 10 zeigt und Fig. 6 einen Querschnitt parallel zur Seitenansicht auf die elektrische Vorrichtung 10 zeigt.

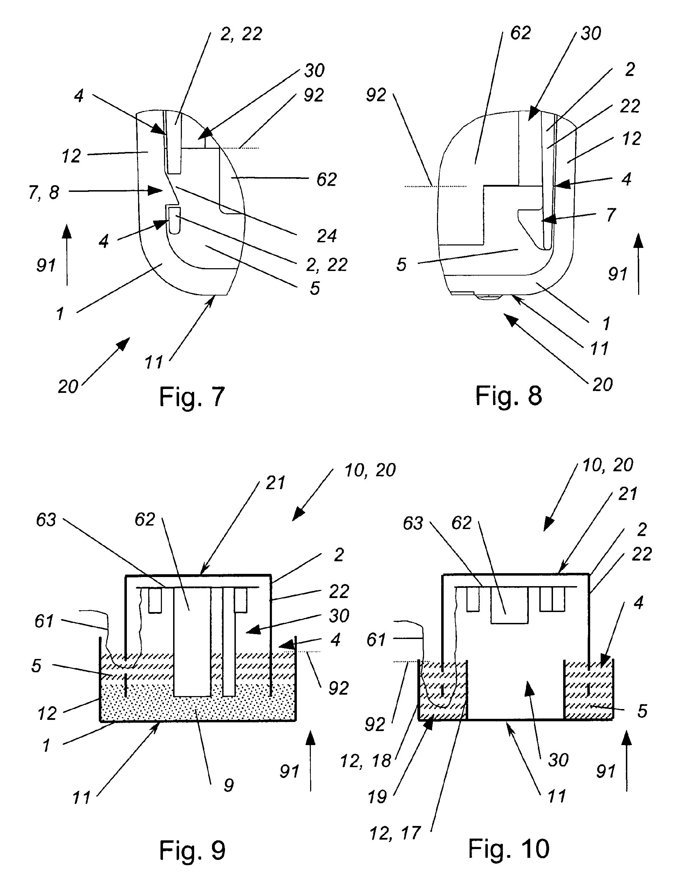

Mit Hinterschnitten, insbesondere Einbuchtungen oder Durchbrechungen 24, und/oder Haken, insbesondere Rastnasen, können die erste Mantelfläche 12 und/oder die zweite Mantelfläche 22 derart gestaltet werden, dass ein gegenseitiges Einrasten der beiden Gehäuseschalen 1, 2 sichergestellt werden kann und gleichzeitig eine hohe Fixierung der ersten Gehäuseschale 1 mit der zweiten Gehäuseschale 2 durch die Vergussmasse 5 ausgebildet werden kann. Derartige - Befestigungsmittel 7 und/oder Positioniermittel 8 ausbildende - Hinterschnitte, Einbuchtungen, Durchbrechungen, Haken und/oder Rastenasen sind in Fig. 7 und 8 schematisch dargestellt, welche Fig. 7 und 8 Teile der ersten Ausführungsform der elektrischen Vorrichtung 10 zeigen.

In Fig. 7 ist schematisch geschnitten im Detail eine vorteilhafte erste Ausbildung des Befestigungsmittels 7 dargestellt, welches Befestigungsmittel 7 gleichzeitig zur relativen Lagefixierung von erster Gehäuseschale 1 zur zweiten Gehäuseschale 2 verwendet wird und derart auch als Positioniermittel 8 ausgebildet ist. Dazu kann an der ersten Mantelfläche 12 - wie dargestellt - die Rastnase ausgebildet sein und - im zusammengesetzten Gehäuse 20 - gegengleich dazu an der zweiten Mantelfläche 22 die Einbuchtung, insbesondere die Durchbrechung 24, angeordnet sein. Beim Einschieben der zweiten Gehäuseschale 2 in die erste Gehäuseschale 1 kann die Gehäusenase in der Einbuchtung, insbesondere in der Durchbrechung 24, einrasten. Dabei kann weiters vorgesehen sein, dass das Befestigungsmittel 7 - nach Herstellung der elektrischen Vorrichtung 10 - vollständig von der erhärteten Vergussmasse 5 eingeschlossen ist. Vorteilhaft dabei ist die zuverlässige Fixierung von der ersten Gehäuseschale 1 mit der zweiten Gehäuseschale 2, wobei zwischen erster Gehäuseschale 1 und zweiter Gehäuseschale 2 große Kräfte übertragen werden können. Durch diese massive Verbindung der beiden Gehäuseschalen 1, 2 und der entsprechenden Auslegung der Gehäusewände kann insbesondere auf Mittel zum Druckausgleich verzichtet werden.

In Fig. 8 ist schematisch geschnitten im Detail eine vorteilhafte zweite Ausbildung des Befestigungsmittels 7 dargestellt. Bei dieser Ausbildung kann in vorteilhafter Weise vorgesehen sein, dass die Rastnase an der zweiten Mantelfläche 22 ausgebildet ist. Nach dem Einfüllen der vorbestimmten Menge der - dazu flüssigen - Vergussmasse 5 und nach dem vorgebbaren Verteilen der - dazu flüssigen - Vergussmasse 5 entlang der Grundfläche 11 kann insbesondere vorgesehen sein, dass die Rastnase an der zweiten Mantelfläche 22 vollständig von der Vergussmasse 5 eingeschlossen wird. Nach dem Erhärten der Vergussmasse 5 ist die Rastnase fixiert und derart ist die Rastnase der zweiten Gehäuseschale 2 formschlüssig in der Vergussmasse 5 eingegossen. Auch hierbei können zwischen erster Gehäuseschale 1 und zweiter Gehäuseschale 2 große Kräfte übertragen werden. Auch hiebei kann - insbesondere bei entsprechender Auslegung der Gehäusewände - auf Mittel zum Druckausgleich verzichtet werden.

Bei einer anderen vorteilhaften Ausführungsform des Befestigungsmittels 7 kann vorgesehen sein, dass dieses lediglich als Durchbrechung 24 in der zweiten Mantelfläche 22 ausgebildet ist. Bei der Herstellung der elektrischen Vorrichtung 20 dringt die Vergussmasse 5 in die Durchbrechung 24 ein und durch diese hindurch. Hiebei bildet die Vergussmasse 5 die Einrastung aus, womit auch hierbei zwischen erster Gehäuseschale 1 und zweiter Gehäuseschale 2 große Kräfte übertragen werden können und insbesondere auf Mittel zum Druckausgleich verzichtet werden kann.

Insbesondere wenn die Vergussmasse 5 als klebend, insbesondere als Klebstoff, ausgebildet ist, kann auf Befestigungsmittel 7 gänzlich verzichtet werden. Üblicherweise kann dabei die oberflächige Klebekraft der Vergussmasse 5 auf die zweite Mantelfläche 22 zur - insbesondere luftdichten - Versiegelung des Gehäuses 10 ausreichen.

Das Befestigungsmittel 7 kann - insbesondere wenn dieses vollständig von der erhärteten Vergussmasse 5 eingeschlossen ist - derart ausgebildet sein, dass die erste Gehäuseschale 1 und die zweite Gehäuseschale 2 lediglich unter Zerstörung des Gehäuses voneinander trennbar sind.

In vorteilhafter Weiterbildung der elektrischen Vorrichtung kann vorgesehen sein, dass die Vergussmasse 5 die Grundfläche 11 im Wesentlichen vollständig bedeckt, und dass - in Normalrichtung 91 auf die Grundfläche 11 gesehen - die erste Gehäuseschale 1 von der Grundfläche 11 weg bis zu einer vorbestimmbaren Vergussfüllhöhe 92 mit der Vergussmasse 5 gefüllt ist, wie dies in Fig. 3 bis 10 dargestellt bzw. ebenso aus den beiden Explosionsdarstellungen hervorgeht. Dazu kann die elektrische Vorrichtung 10 während deren Herstellung derart angeordnet werden, dass die Erdbeschleunigung bzw. eine Zentrifugalkraft diese vorteilhafte Anordnung der Vergussmasse 5 angrenzend an die Grundfläche 11 bewirkt. Insbesondere kann dazu das Gehäuse 20 im Aushärteschritt, in welchem die Vergussmasse aushärtet, entsprechend ruhend gelagert oder entsprechend gleichförmig bewegt wird. Vorteilhaft dabei ist, dass dabei im Wesentlichen die gesamte Grundfläche 11 mit Vergussmasse 5 ausgefüllt ist, also befüllt ist, und die Grundfläche 11 derart verstärkt wird. Hiebei können der Vergussmasse 5 ein oder mehrere Füllstoffe, insbesondere der vorgehend genannten, der Vergussmasse 5 zugesetzt sein.

Die Vergussfüllhöhe 92 kann vorteilhafterweise zwischen 10% und 50% der Erstreckung der elektrischen Vorrichtung 10 entlang der Normalrichtung 91 betragen. Dies kann eine sichere Befüllung mit der Vergussmasse 5 sowie einen sicheren Luftabschluss des Gehäuses 20 und eine sichere Fixierung der zweiten Gehäuseschale 2 relativ zur ersten Gehäuseschale 1 gewährleisten.

Das Volumen der Vergussmasse 5 kann vorteilhafterweise zwischen 10% und 50% des Volumens der elektrischen Vorrichtung 10 betragen. Auch dies kann eine sichere Befüllung mit der Vergussmasse 5 sowie einen sicheren Luftabschluss des Gehäuses 20 und eine sichere Fixierung der zweiten Gehäuseschale 2 relativ zur ersten Gehäuseschale 1 gewährleisten.

Wenn bei der Herstellung der elektrischen Vorrichtung 10 dieses vorbestimmbar evakuiert wird, kann die Abdichtung des Gehäuses 20 mittels der Vergussmasse 5 besonders zuverlässig erfolgen. Als besonders vorteilhaft hat sich dabei eine Evakuierung des Gehäusehohlraums 30 auf in etwa dem 0,7fachen des auf das Meeresniveau bezogenen Normdrucks erwiesen. Insbesondere kann dazu vorgesehen sein, dass die Montage unter gegenüber Normdruck verringertem Druck erfolgt.

Bei einer anderen Ausführungsform kann vorgesehen sein, dass der Gehäusehohlraum 30 unter - auf Normdruck bezogen - Überdruck, beispielsweise dem 1,2fachen des Normdrucks, gestellt wird. Derart kann sichergestellt werden, dass - wenn eine Luftundichtheit am Gehäuse 20 auftritt - zuerst das in den Gehäusehohlraum 30 gefüllte Gas austritt und erst anschließend Fluide in den Gehäusehohlraum 30 eindringen können.

Um das Gehäuse 20 möglichst gering mit Kräften zu belasten kann vorgesehen sein, dass der Gehäusehohlraum 30 unter im Wesentlichen auf Normdruck, also zwischen dem 0,95fachen und dem 1,05fachen des Normdrucks, gestellt wird.

In vorteilhafter Weiterbildung kann vorgesehen sein, dass der Gehäusehohlraum 30 bei der Herstellung der elektrischen Vorrichtung 10 mit einem Schutzgas, beispielsweise mit Kohlendioxid oder mit Stickstoff, befüllt wird.

Vorteilhafterweise kann dem im Gehäusehohlraum 30 befindlichen Gas ein bei Luftzutritt aushärtendes Fluid zugesetzt sein. Kleine Undichtheiten können dabei in vorteilhafter Weise selbsttätig verschlossen werden.

In besonders vorteilhafter Ausführungsform der elektrischen Vorrichtung 10 kann vorgesehen sein, dass die zweite Mantelfläche 22 eine freie Mantelkante 23 aufweist, dass die freie Mantelkante 23 vollumfänglich in sich geschlossen ist, dass die freie Mantelkante 23 - in der zusammengebauten elektrischen Vorrichtung 10 - zwischen der Vergussfüllhöhe 92 und der Grundfläche 11 angeordnet ist, wie dies bei der ersten, der zweiten, der dritten und der vierten Ausführungsform der elektrischen Vorrichtung 10 vorgesehen ist.

In vorteilhafter Weiterbildung kann insbesondere vorgesehen sein, dass die freie Mantelkante 23 vollständig von der Vergussmasse 5 umschlossen ist, wie dies in Fig. 7 bis 10 dargestellt ist. Derart kann das Gehäuse 20 auch bei großen Druckunterschieden zwischen dem Gehäuseinnendruck und dem Umgebungsdruck, beispielsweise bei Druckunterschieden bis zum 2fachen Normdruck, mit hoher Zuverlässigkeit und hoher Dauerhaftigkeit luftdicht, insbesondere somit staub- und wasserdicht, verschlossen sein.

Besonders bevorzugt kann vorgesehen sein, dass die erste Gehäuseschale 1 einstückig ausgebildet ist. Besonders bevorzugt kann weiters vorgesehen sein, dass die zweite Gehäuseschale 2 einstückig ausgebildet ist. Insbesondere wenn beide Gehäuseschalen 1, 2 jeweils einstückig ausgebildet sind, ist lediglich der Mantelspalt 4 abzudichten, also zu verschließen, womit das Gehäuse 20 einfach und kostengünstig verschlossen, insbesondere im Wesentlichen luftdicht, staubdicht und/oder wasserdicht ausgebildet, werden kann.

Die erste Gehäuseschale 1 und/oder die zweite Gehäuseschale 2 können aus wenigstens einem geeignetem Werkstoff ausgebildet sein. Insbesondere können die Gehäuseschalen 1, 2 im Wesentlichen aus Metall, beispielsweise Metallblech, und/oder aus Kunststoff, beispielsweise Thermoplast und/oder Kunststoffcompositwerkstoffen, hergestellt sein.

Die elektrische Vorrichtung 10 umfasst auch eine elektrische Bauteileanordnung 6. Die elektrische Bauteileanordnung 6 umfasst wenigstens ein elektrisches und/oder elektronisches Bauteil 62 und kann insbesondere wenigstens eine Leiterplatte 63 sowie insbesondere wenigstens die eine Kontaktierungsleitung 61 zum elektrischen Kontaktieren der elektrische Vorrichtung 10 umfassen. Insbesondere kann ein außerhalb des Gehäuses angeordnetes Ende der Kontaktierungsleitung 61 einen Stecker 65 umfassen. Im geschlossenen Gehäuse 20 sind die Bauteile 62 im Gehäusehohlraum 30 angeordnet. Die Leiterplatte 63 - wenn vorhanden - ist im geschlossenen Gehäuse 20 im Gehäusehohlraum 30 angeordnet. Die Kontaktierungsleitung 61 ist im geschlossenen Gehäuse 20 bereichsweise im Gehäusehohlraum 30 sowie bereichsweise Anordnung außerhalb des Gehäuses 20 angeordnet. Vorteilhafte Ausführungsformen der elektrischen Bauteileanordnung 6, welche Ausführungsformen mehrere Bauteile 62, mehrere Kontaktierungsleitungen 61 und eine Leiterplatte 63 umfassen, sind schematisch in Fig. 1 bis 6, 9 und 10 dargestellt.

Bei der elektrischen Vorrichtung 10 kann in vorteilhafter Weise vorgesehen sein, dass Lötstellen der elektrischen Bauteileanordnung 6, insbesondere sämtliche Lötstellen der elektrischen Bauteileanordnung 6, beabstandet zur Vergussmasse 5 angeordnet sind. Vorteilhaft dabei ist, dass die Lötstellen nicht in Kontakt mit der Vergussmasse 5 sind. Vorteilhaft dabei ist, dass die Lötstellen gering wärmespannungsbelastet und besonders dauerhaft ausgebildet sein können und somit eine hohe Anzahl, insbesondere über 1000, Temperaturlastwechsel zuverlässig zerstörungsfrei überdauern können. Die von der elektrischen Vorrichtung 10 umfassten Lötstellen können insbesondere zum Verbinden elektrischer Leitungen der Bauteile 62, elektrischen Leitungen der Bauteile 62 mit Leiterbahnen der Leiterplatte 63, der Kontaktierungsleitung 61 mit wenigstens einer Leitung der Bauteile 62 und/oder der Kontaktierungsleitung 61 mit wenigstens einer Leiterbahn der Leiterplatte 63 vorgesehen und ausgebildet sein.

Insbesondere kann vorgesehen sein, dass die Leiterplatte 63 benachbart zur Deckfläche 21 im Gehäusehohlraum 30 angeordnet ist, so dass die Leiterplatte 63 beabstandet zur Vergussmasse 5 angeordnet ist. Von der Leiterplatte 63 können die Bauteile 62 in Richtung des Zentrums des Gehäuses 20 und in Richtung der Vergussmasse 5 abragen. Vorteilhaft dabei ist, dass auf der Leiterplatte 63 befindliche Lötstellen, insbesondere sämtliche dieser Lötstellen, nicht in Kontakt mit der Vergussmasse 5 sind. Die derartige Anordnung der Leiterplatte 63 ist bei der ersten, der zweiten, der dritten und der vierten Ausführungsform der elektrischen Vorrichtung 10 vorgesehen.

Vorteilhafterweise kann zumindest eines des wenigstens einen Bauteils 62 bereichsweise die Vergussmasse 5 kontaktieren, insbesondere bereichsweise in die Vergussmasse 5 hineinragen, wie dies in Fig. 3 bis 8 dargestellt ist. Vorteilhaft dabei ist, dass ein großes bzw. schweres Bauteil 62 dabei von der Vergussmasse 5 besonders zuverlässig fixiert werden kann. Vorteilhaft dabei ist, dass die Vergussmasse 5 eine höhere thermische Leitfähigkeit als das den Gehäusehohlraum 30 ausfüllende Fluid, insbesondere Gas, vorteilhafterweise Schutzgas, aufweisen kann, womit das die Vergussmasse 5 kontaktierende Bauteil 62 besser gekühlt werden kann. Insbesondere kann zum guten Wärmeabtransport ein Kühlblech in die Vergussmasse 5 hineinragen.

Das bereichsweise Hineinragen eines Bauteiles 62 in die Vergussmasse 5 bewirkt dabei die Ausbildung eines jeweilig zum Bauteil 62 bereichsweise gegengleichen Eintauchabdrucks 51 in der Vergussmasse 5. Derartige Eintauchabdrücke 51 sind in Fig. 1 und Fig. 2 - in welchen die bereits erhärtete Vergussmasse 5 schematisch dargestellt ist - sichtbar. Vorteilhaft dabei ist, dass die flüssige Vergussmasse 5 das Bauteile 62 einfach und zuverlässig bereichsweise umschließen kann, womit ein guter thermischer und/oder mechanischer Kontakt zwischen dem Bauteil 62 und der Vergussmasse 5 gegeben sein kann.

Vorteilhafterweise kann vorgesehen sein, dass - in der zeitlichen Abfolge - vor dem Schalenanordnungsschritt eine elektrische Bauteileanordnung 6 an der zweiten Gehäuseschale 2 montiert und lagefixiert wird. Die ermöglicht eine besonders einfache Montage der elektrischen Vorrichtung 10. Auch hiebei kann vorgesehen sein, entweder dass der Schalenanordnungsschritt vor dem Vergussbefüllschritt durchgeführt wird, oder dass der Vergussbefüllschritt vor dem Schalenanordnungsschritt durchgeführt wird. Insbesondere kann hiebei vorgesehen sein, dass Lötstellen, insbesondere sämtliche Lötstellen, welche zur Anordnung im Gehäusehohlraum 30 vorgesehen sind, der elektrischen Bauteileanordnung 6 benachbart zur Deckfläche 21 angeordnet werden. Damit kann zuverlässig gewährleistet werden, dass die Lötstellen der elektrischen Bauteileanordnung 6 während des gesamten Herstellprozesses beabstandet zur Vergussmasse 5 sind.

Ebenso kann vorgesehen sein, insbesondere wenn die Vergussmasse 5 eine ausreichende lange Aushärtezeit aufweist, dass die elektrische Bauteileanordnung 6 zeitlich vor dem Schalenanordnungsschritt relativ zur ersten Gehäuseschale 1 lagefixiert wird. Dazu kann, zur Positionierung von der elektrischen Bauteileanordnung 6 relativ zur ersten Gehäuseschale 1, die elektrischen Vorrichtung 10 in vorteilhafter Weise Lagepositioniermittel umfassen, welche die Lage der elektrischen Bauteileanordnung 6 relativ zur ersten Gehäuseschale 1 festlegen. Die Lagepositioniermittel können anschließend im Schalenanordnungsschritt von der Vergussmasse 5 umschlossen werden. Vorteilhaft dabei ist, dass die elektrische Bauteileanordnung 6 in der elektrischen Vorrichtung 10 beabstandet und kontaktfrei zur zweiten Gehäuseschale 2 angeordnet werden kann.

Bei einem anderen vorteilhaften Verfahren der Herstellung der elektrischen Vorrichtung 10 kann vorgesehen sein, dass zuerst der Schalenanordnungsschritt durchgeführt wird, anschließend daran die elektrische Bauteileanordnung 6 bereichsweise in die Vergussmasse 5 eingesteckt und positioniert wird und wiederum anschließend daran der Vergussbefüllschritt durchgeführt wird. Derart kann auf die zweiten Positioniermittel verzichtet werden und die elektrische Bauteileanordnung 6 kann einfach und kostengünstig relativ zur ersten Gehäuseschale 1 lagepositioniert sein und gegebenenfalls beabstandet und kontaktfrei zur zweiten Gehäuseschale 2 angeordnet werden. Dabei wird die elektrische Bauteileanordnung 6 in vorteilhafter Weise im Wesentlichen lediglich durch die Vergussmasse 5 gehalten und in deren Lage fixiert.

Fig. 9 zeigt schematisch geschnitten die vorteilhafte dritte Ausführungsform der elektrischen Vorrichtung 10. Bei der dritten Ausführungsform ist vorgesehen, dass - insbesondere in Normalrichtung 91 gesehen - unmittelbar angrenzend an die Grundfläche 11 eine Füllmasse 9 angeordnet ist und dass die Vergussmasse 5 wiederum angrenzend an die Füllmasse 9 angeordnet ist. Derart ist die Vergussmasse 5 beabstandet zur Grundfläche 11 angeordnet und die Füllmasse 9 füllt den Raum zwischen Vergussmasse 5 und Grundfläche 11.

Die Füllmasse 9 kann zur Verbesserung der Wärmeleitfähigkeit des Gehäuses 20, zur Versteifung des Gehäuses 20 und/oder zur Isolation, insbesondere zur Wärmeisolation, zur Schalldämmung und/oder zur elektromagnetischen Isolation, vorgesehen sein. Die Füllmasse 9 kann dazu aus geeignetem Material, insbesondere aus Metall, als Holz und/oder aus Kunststoff, gefertigt sein und kann geschäumt und/oder faserverstärkt ausgebildet sein. Die zweite Gehäuseschale 2 und/oder wenigstens ein Bauteil 62 können die Füllmasse 9 bereichsweise kontaktieren, wie dies in Fig. 9 dargestellt ist.

Bei geringfügiger Abwandlung der dritten Ausführungsform kann vorgesehen sein, dass zweite Gehäuseschale 2 und das wenigstens eine Bauteil 62 beabstandet und kontaktfrei zur Füllmasse 9 angeordnet sind.

Fig. 10 zeigt schematisch geschnitten die vorteilhafte vierte Ausführungsform der elektrischen Vorrichtung 10. Bei dieser Ausführungsform kann vorgesehen sein, dass die erste Gehäuseschale 1 zwei erste Mantelflächen 12 umfasst, welche eine innere erste Mantelfläche 17 und eine äußere erste Mantelfläche 18 ausbilden. Zwischen den der inneren ersten Mantelfläche 17 und der äußeren ersten Mantelfläche 18 ist derart ein Kanal 19 ausgebildet, welcher zur Befüllung mit der Vergussmasse 5 vorgesehen ist. Die zweite Mantelfläche 22 ist dabei zur bereichsweisen Anordnung innerhalb des Kanals 19 vorgesehen. Zwischen der zweiten Mantelfläche 22 und der äußeren ersten Mantelfläche 18 ist dabei der Mantelspalt 4 ausgebildet und zwischen der zweiten Mantelfläche 22 und der inneren ersten Mantelfläche 17 ist ein zweiter Zwischenspalt ausgebildet. Auch hiebei ist der Mantelspalt 4 vollumfänglich von der, die äußere erste Mantelfläche 18 ausbildenden, ersten Mantelfläche 12 umschlossen.

Dabei kann die wirksame Spalthöhe, welche normal auf die Spaltbreite und den Spaltumfang ausgebildet ist, verdoppelt werden und der Mantelspalt 4 und der zweite Zwischenspalt können als Doppelspalt bezeichnet werden. Vorteilhaft bei dieser Ausführungsform der elektrischen Vorrichtung 10 ist, dass die zum zuverlässigen und dauerhaften - insbesondere luftdichten - Verschließen der elektrischen Vorrichtung 10 benötige Vergussmasse 5 besonders gering sein kann. In vorteilhafter Weise können derart der Gehäusehohlraum 30 besonders großvolumig, das Gewicht der elektrischen Vorrichtung 10 besonders niedrig und/oder die Abdichtwirkung - insbesondere durch die Verdopplung der wirksamen Spalthöhe - besonders zuverlässig und dauerhaft stabil ausgebildet sein.

Weitere erfindungsgemäße Ausführungsformen weisen lediglich einen Teil der beschriebenen Merkmale auf, wobei jede Merkmalskombination, insbesondere auch von verschiedenen beschriebenen Ausführungsformen und/oder Ausbildungen, vorgesehen sein kann.

## Patentansprüche

1. Elektrische Vorrichtung (10) mit einer elektrischen Bauteileanordnung (6) und mit einem Gehäuse (20), insbesondere einem staub- und/oder wasserdichten Gehäuse (20), wobei das Gehäuse (20) eine erste Gehäuseschale (1) und eine zweite Gehäuseschale (2) umfasst, wobei die erste Gehäuseschale (1) eine Grundfläche (11) und eine geschlossene erste Mantelfläche (12) und die zweite Gehäuseschale (2) eine Deckfläche (21) und eine geschlossene zweite Mantelfläche (22) umfasst, wobei unter Ausbildung eines Gehäusehohlraums (30) die zweite Gehäuseschale (2) wenigstens bereichsweise innerhalb der ersten Gehäuseschale (1) angeordnet ist, wobei die zweite Mantelfläche (22) wenigstens bereichsweise von der ersten Mantelfläche (12) umschlossen ist, wobei zwischen der ersten Mantelfläche (12) und der zweiten Mantelfläche (22) ein Mantelspalt (4) ausgebildet ist, **dadurch gekennzeichnet, dass** der Mantelspalt (4) mit einer Vergussmasse (5) verschlossen ist.

2. Elektrische Vorrichtung nach Anspruch 1, **dadurch gekennzeichnet, dass** die Vergussmasse (5) die Grundfläche (11) im Wesentlichen vollständig bedeckt, und dass - in Normalrichtung (91) auf die Grundfläche (11) gesehen - die erste Gehäuseschale (1) von der Grundfläche (11) weg bis zu einer vorbestimmbaren Vergussfüllhöhe (92) mit der Vergussmasse (5) gefüllt ist.

3. Elektrische Vorrichtung nach Anspruch 1 oder 2, **dadurch gekennzeichnet, dass** Lötstellen, insbesondere sämtliche Lötstellen, der elektrischen Bauteileanordnung (6) beabstandet zur Vergussmasse (5) angeordnet sind.

4. Elektrische Vorrichtung nach Anspruch 1, 2 oder 3, **dadurch gekennzeichnet, dass** eine Leiterplatte (63) der elektrischen Bauteileanordnung (6) benachbart zur Deckfläche (21) angeordnet ist.

5. Elektrische Vorrichtung nach einem der Ansprüche 2 bis 4, **dadurch gekennzeichnet, dass** die zweite Mantelfläche (22) eine freie Mantelkante (23) aufweist, dass die freie Mantelkante (23) vollumfänglich in sich geschlossen ist, dass die freie Mantelkante (23) zwischen der Vergussfüllhöhe (92) und der Grundfläche (11) angeordnet ist, und dass die freie Mantelkante (23) vollständig von der Vergussmasse (5) umschlossen ist.

6. Elektrische Vorrichtung nach einem der Ansprüche 1 bis 5, **dadurch gekennzeichnet, dass** die zweite Mantelfläche (22), im Bereich in welchem diese von der Vergussmasse (5) umschlossen ist, wenigstens eine Durchbrechung (24) aufweist.

7. Elektrische Vorrichtung nach einem der Ansprüche 1 bis 6, **dadurch gekennzeichnet, dass** die zweite Mantelfläche (22), im Bereich in welchem diese beabstandet zur Vergussmasse (5) angeordnet ist, durchbrechungsfrei ausgebildet ist.

8. Elektrische Vorrichtung nach einem der Ansprüche 1 bis 7, **dadurch gekennzeichnet, dass** zur Befestigung bzw. zum Verrasten der ersten Gehäuseschale (1) mit der zur zweiten Gehäuseschale (2) die erste Mantelfläche (12) und/oder die zweite Mantelfläche (22) Befestigungsmittel (7), insbesondere Einrastmittel, aufweisen.

9. Elektrische Vorrichtung nach einem der Ansprüche 1 bis 8, **dadurch gekennzeichnet, dass** die erste Gehäuseschale (1) einstückig ausgebildet ist und dass die zweite Gehäuseschale (2) einstückig ausgebildet ist.

10. Elektrische Vorrichtung nach einem der Ansprüche 1 bis 9, **dadurch gekennzeichnet, dass** die elektrische Vorrichtung (10) zur elektrischen Kontaktierung wenigstens eine Kontaktierungsleitung (61) umfasst, und dass die Kontaktierungsleitung (61) bereichsweise vollumfänglich von der Vergussmasse (5) umschlossen sind.

11. Elektrische Vorrichtung nach einem der Ansprüche 1 bis 10, **dadurch gekennzeichnet, dass** wenigstens ein Bauteil (62), insbesondere wenigstens ein elektrisches Bauteil, der elektrischen Vorrichtung (10) bereichsweise von der Vergussmasse (5) kontaktiert ist.

12. Verfahren zur Herstellung einer elektrischen Vorrichtung (10) mit einem Gehäuse (20), insbesondere einem staub- und/oder wasserdichten Gehäuse (20), **gekennzeichnet** die Schritte:
- dass in einem Schalenanordnungsschritt eine zweite Mantelfläche (22) einer zweiten Gehäuseschale (2) derart bereichsweise in eine erste Mantelfläche (12) einer ersten Gehäuseschale (1) geführt wird, dass die zweite Mantelfläche (22) zumindest bereichsweise von der ersten Mantelfläche (12) umschlossen wird, und dass zwischen der ersten Mantelfläche (12) und der zweiten Mantelfläche (22) ein Mantelspalt (4) ausgebildet wird, und
- dass in einem Vergussbefüllschritt die erste Gehäuseschale (1) bis zu einer vorbestimmbaren Vergussfüllhöhe (92) mit einer Vergussmasse (5) befüllt wird.

13. Verfahren nach Anspruch 12, **dadurch gekennzeichnet, dass** - in zeitlicher Abfolge - der Schalenanordnungsschritt vor dem Vergussbefüllschritt durchgeführt wird.

14. Verfahren nach Anspruch 11 oder 12, **dadurch gekennzeichnet, dass** - in zeitlicher Abfolge - vor dem Schalenanordnungsschritt eine elektrische Bauteileanordnung (6) an der zweiten Gehäuseschale (2) montiert und lagefixiert wird.

15. Verfahren nach Anspruch 13, **dadurch gekennzeichnet, dass** Lötstellen, insbesondere sämtliche Lötstellen, welche zur Anordnung in einem Gehäusehohlraum (30) des Gehäuses (20) vorgesehen sind, der elektrischen Bauteileanordnung (6) benachbart zur Deckfläche (21) angeordnet werden.
